# EUROPEAN PATENT SPECIFICATION

(11) **EP 1 003 200 B1**
(45) Date of publication and mention of the grant of the patent: **02.06.2004**
(21) Application number: 99204274.7
(22) Date of filing: 08.08.1996
(51) Int. Cl.: H01J 37/20

(54) **High temperature specimen stage and detector for an environmental scanning electron microscope**
Hochtemperatur-Probentisch und Detektor für Rasterelektronenmikroskop unter kontrollierter Umgebung
Platine porte-objet et détecteur haute température pour microscope électronique à balayage en atmosphère

(43) Date of publication of application: 24.05.2000
(62) Divisional of application: 96928086.6
(73) Proprietor: FEI COMPANY, Hillsboro, OR 97124-5830 (US)
(72) Inventor: Knowles, Ralph W., 5656 AA Eindhoven (NL); Hardt, Thomas A., 5656 AA Eindhoven (NL)
(74) Representative: Bakker, Hendrik

(56) References cited:
- US-A- 4 705 949
- US-A- 4 789 781
- US-A- 5 412 211

## Description

### Field of the Invention

This invention relates to the field of environmental scanning electron microscopes ("ESEM"), and more particularly, to a hot temperature stage for an environmental scanning electron microscope which is capable of heating a specimen up to a temperature of approximately 1500°C, and the application of a detector in such ESEM which allows imaging of the specimen at high temperatures.

### Specific Field of the Invention

More specifically, the invention relates to an environmental scanning electron microscope comprising:
(a) means for generating and directing an electron beam through a final pressure limiting aperture toward a specimen under examination, and
(b) a specimen chamber which maintains the specimen enveloped in gas in registration with said final limiting aperture, said specimen chamber including a specimen stage comprising sample platform means for supporting the specimen under examination and specimen heating means for heating said specimen. Such environmental scanning electron microscope is known from the US patent No. 4,705,949. This microscope known from said US patent is provided with a specimen chamber which maintains the specimen enveloped in gas; to that end the specimen chamber consists of a lower and an upper part, these two parts in combination forming a closed specimen cell. In said patent description it is not described that the upper part has heat shielding properties. It is also not known from said patent description to detect electrons emanating from the sample.

### Background of the Invention

As background, the advantages of a environmental scanning electron microscope over the standard scanning electron microscope ("SEM") lie in its ability to produce high-resolution electron images of moist or non-conductive specimens (e.g., biological materials, plastics, ceramics, fibres) which are extremely difficult to image in the usual vacuum environment of the SEM. The environmental scanning electron microscope allows the specimen to be maintained in its "natural" state, without subjecting it to the distortions caused by drying, freezing, or vacuum coating normally required for high-vacuum electron beam observation. Also, the relatively high gas pressure easily tolerated in the ESEM specimen chamber acts effectively to dissipate the surface charge that would normally build up on a non-conductive specimen, blocking high quality image acquisition. The ESEM also permits direct, real-time observation of liquid transport, chemical reaction, solution, hydration, crystallization, and other processes occurring at relatively high vapour pressures, far above those that can be permitted in the normal SEM specimen chamber.

Typically, in an ESEM, the electron beam is emitted by an electron gun and passes through an electron optical column of an objective lens assembly having a final pressure limiting aperture at its lower end thereof. In the electron optical column, the electron beam passes through magnetic lenses which are used to focus the beam and direct the electron beam through the final pressure limiting aperture.

The beam is subsequently directed into a specimen chamber through the final pressure limiting aperture wherein it impinges upon a specimen supported upon a specimen stage. The specimen stage is positioned for supporting the specimen approximately 1 to 10 mm below the final pressure limiting aperture so as to allow the beam of electrons to interact with the specimen. The specimen chamber is disposed below the optical vacuum column and is capable of maintaining the sample enveloped in gas, preferably nitrogen or water vapour, at a pressure of approximately between 1,3 N/m² and 65x10² N/m² (10⁻² and 50 Torr) in registration with the final pressure limiting aperture such that a surface of the specimen may be exposed to the charged particle beam emitted from the electron gun and directed through the final pressure limiting aperture.

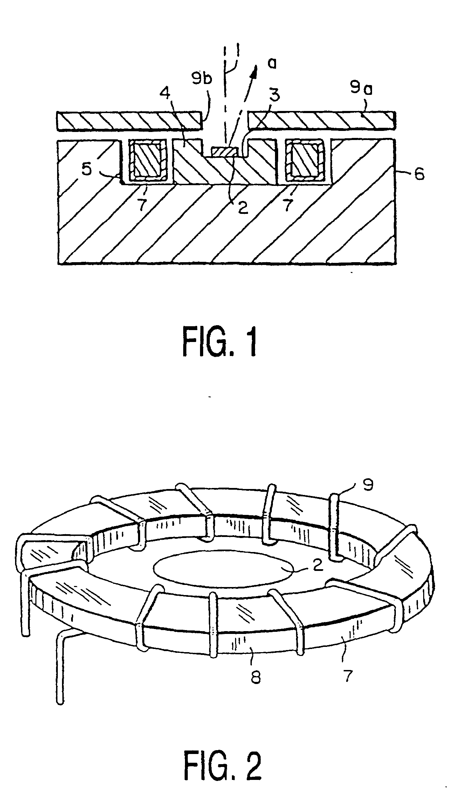

The typical specimen stage previously used in an environmental scanning electron microscope to image samples at high temperatures is illustrated in Figure 1. In that prior specimen stage, the electron beam 1 strikes a surface of the specimen 2 which is supported in a recess 3 of a sample cup 4 which is supported in a depression 5 of an insulating jacket 6. An annular heating assembly is provided in the depression 5 between the insulating jacket 6 and the sample cup 4, which is best shown in Figure 2. This heater assembly 7 is formed of an annular toroidal ceramic former 8 having a heater wire 9 wound therearound such that the heater wire 9 is provided remote from the sample 2 and does not extend above the sample. In the prior specimen stage of Fig. 1, a heat shield 9a is positioned on top of the sample cup 4, the insulated jacket 6, and the heater assembly 7 which has a central opening 9b such that the electron beam can pass therethrough and strike the specimen 2.

For the reasons set forth below, the prior specimen stage for an environmental scanning electron microscope shown Figures 1 and 2 has disadvantageously been unable to achieve sample temperatures of at least 1500°C. First, the heater wire 9 cannot be made of tungsten because it will oxidize in the water vapour of the environmental scanning electron microscope. Hence, platinum wire must be used, but platinum melts at 1700°C. Second, the heater is provided too remote from the sample and is significantly hotter than the sample. Finally, heat is radiated and converted from the surface of the sample as is represented by arrow a in Figure 1 so that the bottom of the sample is hotter than the top, but the user is observing the top of the sample and the top surface cannot then be maintained at temperatures of at least 1500°C due to this radiant heat loss. Hence, utilizing the toroidal heater of Figures 1 and 2 in an environmental scanning electron microscope failed to achieve a sample temperature of 1500°C.

### Objects of the Invention

Therefore, it is an object of the present invention to provide a hot temperature specimen stage for an environmental scanning electron microscope which avoids the aforementioned deficiencies of the prior art, and which preferably achieves a sample temperature of at least approximately 1500°C.

Various other objects, advantages and features of the present invention will become readily apparent from the ensuing detailed description and the novel features will be particularly pointed out in the appended claims.

### Summary of the Invention

The environmental scanning electron microscope according to the present invention is defined by claims 1 and 2. Preferred embodiments are setout in the dependent claims.

This invention relates to a hot temperature specimen stage for an environmental scanning electron microscope which is capable of achieving a sample temperature of up to at least approximately 1500°C. In the environmental scanning electron microscope in which this hot temperature specimen stage is employed, an electron beam is generated by an electron gun which passes through an electron optical column until the electron beam is focused and scanned across the diameter of a final pressure limiting aperture provided at the lower end of the electron optical column. The final pressure limiting aperture separates the relatively high vacuum of the electron optical column from the relative low vacuum of the specimen chamber.

The specimen chamber is positioned below the electron optical column and is capable of maintaining the specimen enveloped in gas in registration with the final pressure limiting aperture such that a surface of the specimen may be exposed to the focused beam of electrons. A specimen stage is located within the specimen chamber and is positioned for supporting the specimen approximately 1 to 25mm below the final pressure limiting aperture so as to allow the focused beam of electrons to interact with the specimen. In the specimen chamber, the specimen is maintained at a pressure between about 1,3 N/m² and 65x10² N/m² (10⁻² and 50 Torr), and preferably approximately 13x10² N/m² (10 Torr).

In the high temperature specimen stage of the environmental scanning electron microscope of this invention, a sample platform is provided for supporting the specimen. The sample platform is in the form of a loose, disposable, sample cup made of a high thermally conductive material which is contained within a recess of an insulating jacket. The specimen is supported in a depression of the sample cup at a first vertical height. In this specimen stage, a specimen heater assembly heats the specimen and may include a non-inductively wound heater wire coil which is positioned closely adjacent to the sample cup. In order to avoid radiant heat loss, a heat shield assembly is provided in the specimen chamber above the specimen heating assembly. This heat shield assembly includes a central opening to permit the electron beam to pass therethrough and strike the sample. The heat shield assembly may include a plurality of thin ceramic insulating shields which act as heat reflectors and a plurality of perforated metal support plates integrally found therewith to avoid warping of the heat shield assembly at high temperatures.

Further, the heat shield assembly is mounted separately from the specimen heater assembly which allows for a larger field of view.

Accordingly, the design of this hot temperature specimen stage for an environmental scanning electron microscope achieves the advantage over the known specimen stage of Fig. 1 in that an adjustable bias voltage of up to approximately 500V can be applied to the heat shield assembly to accelerate secondary electrons emanating from the surface of the specimen to pass through the central opening of the heat shield assembly to be collected by an electron detector assembly. In one embodiment, the electron detector assembly can be in the form of a thin ring electrode, and in order to enhance image quality, the final pressure limiting aperture can be biased at a different voltage than the bias applied to the thin ring electrode. In addition, the bias voltage applied to the final pressure limiting aperture can float to provide for automatic compensation. In order to suppress thermal electrons, a bias voltage of between approximately +50V and -50V can be applied to the sample cup.

In this environmental scanning electron microscope, the heat shield assembly is aligned with respect to the final pressure limiting aperture and the electron detector and is separated from the specimen stage. Thus, the present invention provides a specimen stage moving assembly for laterally moving the specimen stage independently of the heat shield assembly to enhance the field-of-view of the specimen.

### Brief Description of the Drawings

The following detailed description given by way of example, but not intended to limit the invention solely to the specific embodiments described, may best be understood in conjunction with the accompanying drawings in which:
Fig. 1 is schematic representation of a conventional specimen stage used in conjunction with an environmental scanning electron microscope;
Fig. 2 is a schematic representation of a conventional heating assembly used with the specimen stage of Figure 1;
Fig. 3 is a schematic representation of an example of electron trajectory paths in a known environmental scanning electron microscope;
Fig. 4 is a schematic representation of a known embodiment of the environmental scanning electron microscope illustrating preferred electron path trajectories;
Fig. 5 is a schematic representation of a preferred embodiment of a high temperature specimen stage for an environmental scanning electron microscope in accordance with the teachings of the present invention;
Fig. 6 is a schematic representation of a non-inductively wound heater coil incorporated in the heater assembly of the high temperature stage of Figure 5;
Fig. 7 is a schematic representation of the high temperature specimen stage for an environmental scanning electron microscope of Figure 5 which specifically illustrates an adjustable bias voltage being applied to a heat shield assembly;
Fig. 8 is a schematic representation of an improved gaseous electron detector assembly wherein components thereof can be used in conjunction with the high temperature specimen stage for an environmental scanning electron microscope of the present invention illustrated in Fig. 5;
Fig. 9 is a schematic representation of the environmental scanning electron microscope incorporating the high temperature specimen stage of Figure 5 and specifically illustrates a specimen stage moving assembly for moving the specimen stage independently of the heat shield assembly to observe different parts of the specimen under examination and enhance the field-of-view of the specimen;
Fig. 10 is a schematic representation of the high temperature specimen stage for an environmental scanning electron microscope of Fig. 5 and specifically illustrates biasing the final pressure limiting aperture at a different voltage from the secondary electron detector electrode;
Fig. 11 is a schematic representation of the high temperature specimen stage for an environmental scanning electron microscope of Fig. 5 which is similar to Figure 10 and specifically illustrates applying a bias voltage to the sample cup supporting the specimen;
Figs. 12a and 12b are schematic representations of the high temperature specimen stage for an environmental scanning electron microscope of Fig. 5 which specifically illustrates integrally mounting the heat shield assembly with respect to the specimen stage thereby inherently limiting the size of the specimen which can be observed; and
Figs. 13a and 13b are schematic representations of the high temperature specimen stage for an environmental scanning electron microscope of Fig. 5 specifically illustrating the heat shield assembly being aligned with respect to the secondary electron detector and the final pressure limiting so that the specimen stage can be laterally moved independently of the heat shield assembly by a specimen stage moving assembly to observe a larger area of the specimen under examination, and hence, enhance the field-of-view of the specimen.

### Detailed Description of Certain Preferred Embodiments

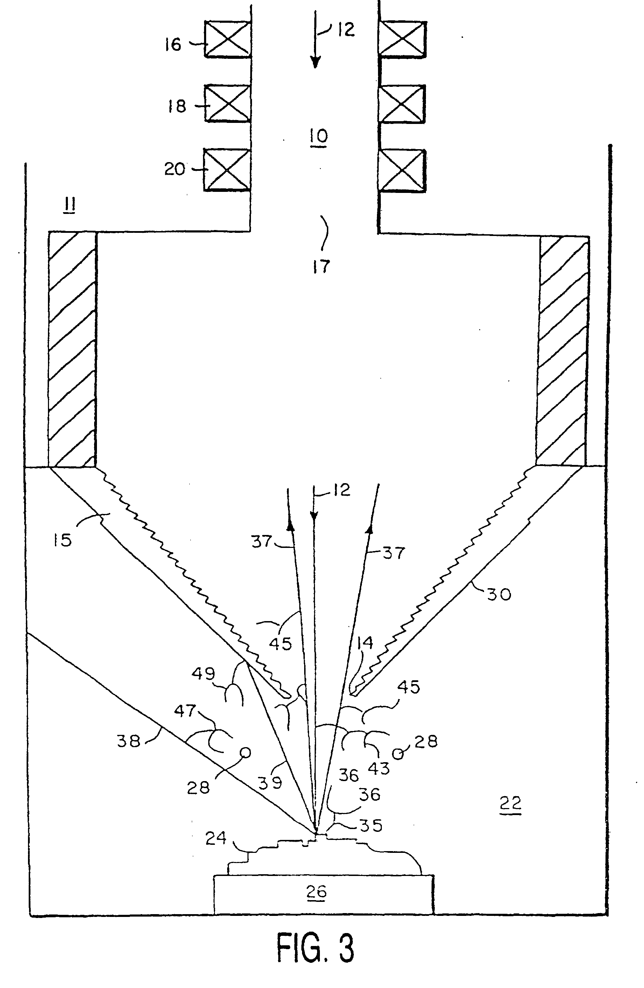

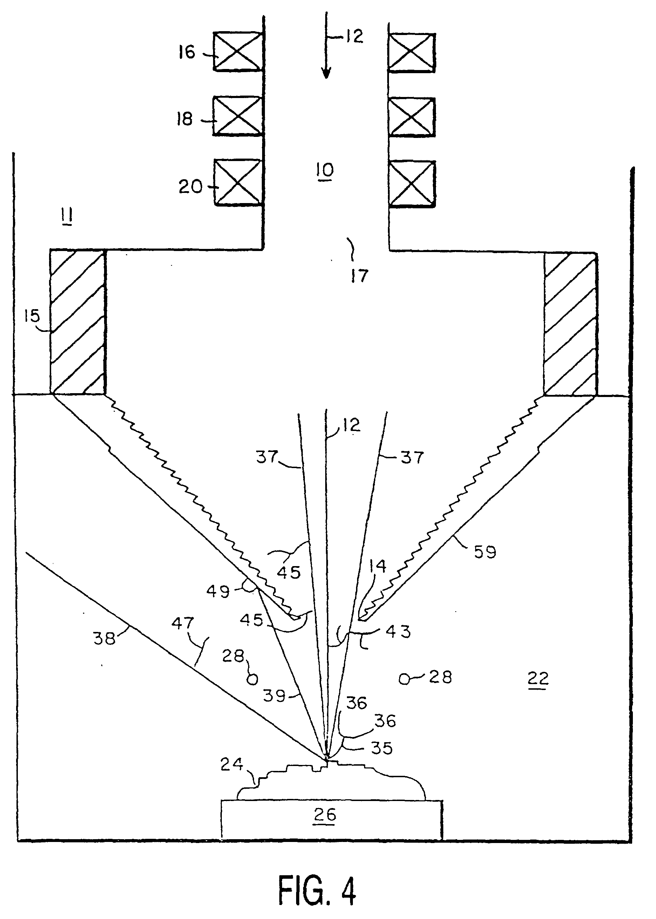

Referring now to Figs. 3 and 4, the prior environmental scanning electron microscope of U.S. Patent Nos. 5,362,964 and 5,412,211 is illustrated. In this environmental scanning electron microscope, a device for generating, amplifying and detecting secondary and backscattered electrons emanating from a surface of a sample being examined is provided. More specifically, a beam of electrons 12 is emitted through an electron optical column 10 and the objective lens assembly 11 by an electron gun (not shown). The electron optical column 10 includes a final pressure limiting aperture 14 at its lower end thereof. The final pressure limiting aperture 14 is formed within the lower end of an aperture carrier 15. This aperture carrier 15 is discussed in U.S. Patent No. 4,823,006. This aperture carrier includes a second pressure limiting aperture 17 positioned above the final pressure limiting aperture 14 which communicates directly with the electron optical column 10. The electron beam passes through magnetic lenses 16 and 18 which are used to control the intensity of the electron beam. Focusing means 20 locating within the objective lens assembly 11 adjacent to the vacuum column is capable of directing the beam of electrons through the final pressure limiting aperture 14.

In the prior ESEM construction of Fig. 3, beam is subsequently directed into a specimen chamber 22 through final pressure limiting aperture 14 wherein it impinges upon a specimen 24 supported on a specimen stage. The specimen mount or stage 26 is located within the specimen chamber 22 and is positioned for supporting specimen 24 approximately 1 to 25mm, and preferably 1 to 10 mm, below final pressure limiting aperture 14 so as to allow the beam of electrons to interact with the specimen. The specimen chamber is disposed below the electron optical column 10 and is capable of maintaining the sample 24 enveloped in gas, preferably nitrogen or water vapour, at a pressure of approximately between 1,3 N/m² and 65x10² N/m² (10⁻² to 50 Torr) in registration with the final pressure limiting aperture such that a surface of the specimen may be exposed to the charged particle beam emitted from the electron gun and directed through the pressure limiting aperture 14.

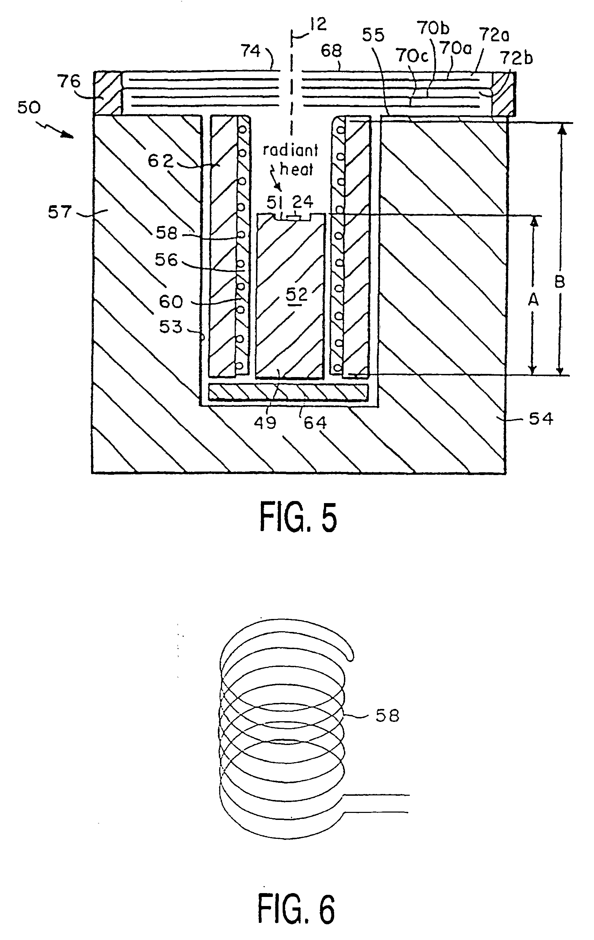

A preferred embodiment of a high temperature specimen stage 50 for an environmental scanning electron microscope of the present invention which achieves a sample temperature of at least approximately 1500°C is shown in Fig. 5. As will be explained in more detail below, this high temperature specimen stage uses the same principle as a standard furnace used to heat samples to high temperatures - the sample is surrounded by a furnace at the high temperature.

As is shown in Fig. 5, in the high temperature specimen stage 50 of the present invention, the specimen 24 is supported on a sample platform 49. The sample platform includes a loose, disposable sample cup 52 which is contained within a recess 53 of an insulating jacket 54. The specimen 24 is supported in a depression 51 formed in the top surface of the sample cup 52 at a first vertical height in the recess 53, designated by reference character A in Fig. 5. In the preferred embodiment, the sample cup 52 is made of a high thermally conductive material, preferably magnesium oxide. As shown in Fig. 5, the annular upper edge 55 of the insulating jacket 54 extends to a height substantially above the first vertical height A of the sample 24 supported in the sample cup 52.

In the specimen stage 50, a specimen heating assembly 56 is supported in the recess 53 of the insulating jacket 54 which heats the specimen under examination. The specimen heater assembly 56 is positioned immediately adjacent to the sample cup 52 and extends to a height which is generally contiguous with the upper edge 55 of the insulating jacket 54. As shown in Figs. 5 and 6, the specimen heater assembly 56 includes a non-inductively wound heater coil 58 which extends the entire length of the heater assembly 56 to a second vertical height in the recess 53, designated by reference character B in Fig. 5, which extends significantly above the first vertical height A of the sample. As a result of this design, the top surface of the specimen is maintained at a high temperature. The specimen heater assembly 56 further includes a ceramic coating 60 (see Fig. 5) covering the heater wire 58 to hold the shape of the heater wire 58. In addition, in order to further insulate the sample platform, avoid further radiant heat loss, and support the heater wire 58, a ceramic tube 62 is positioned in the recess 53 of the insulating jacket 54 between the heater assembly 56 and the upstanding edge 57 of the insulating jacket 54. As is shown in Fig. 5, the sample cup 52, the heater assembly 56, and the ceramic tube 62 are supported within the recess 53 of the insulating jacket 54 by means of an insulated support stand 64 which is attached preferably by cement to the ceramic tube 62. Moreover, the ceramic coating 60 of the heater assembly 56, the ceramic tube 62, the support stand 64, and the insulating jacket 54 are preferably made of aluminium oxide to thereby better direct heat to the sample cup 52.

In order to avoid radiant heat loss upwardly from the specimen heater assembly 56, a heat shield assembly 68 is placed above the sample cup 52, heater assembly 56, ceramic tube 62 and the insulating jacket 54. As is shown in Fig. 5, the heat shield assembly 68 includes a central opening 74 such that the electron beam 12 can pass therethrough and strike the specimen 24 supported on the sample cup 52. The heat shield assembly 68 further includes a plurality of thin ceramic insulating shields, such as 70a, 70b, and 70c, which act as heat reflectors, and a plurality of perforated metal support plates, such as 72a and 72b, integrally formed therewith to avoid warping of the heat shield assembly at high temperatures. In the preferred embodiment, the ceramic insulating shields 70a-c are formed of alumina paper and the metal support plates 72a∼.b are formed of perforated stainless steel. The heat shield assembly 68 including the thin ceramic insulating shields 70a-c and the perforated metal support plates 72a-b is supported in its proper position by means of an annular support ring 76.

Therefore, the design of this hot temperature specimen stage for an ESEM achieves the following advantages over the prior ESEM specimen stage of Figs. 1 and 2; namely:
1. Since the sample cup 52 is made of a high thermally conductive material, the temperature differential between the top and bottom of the sample cup 52 is minimized;
2. Since the heater wire 58 is wound as a coil, the entirety of the heater wire is positioned close to the sample cup 52 in comparison to the prior toroidal heater assembly of Figs. 1 and 2;
3. Since the heater assembly 56 with the heater coil 58 extends significantly above the sample 24, the top of the sample 24 is irradiated by the heater coil 58 in order to maintain the sample at a high temperature.
4. Since the heater wire 58 is wound non-inductively, the magnetic field from the heating current is minimized which otherwise would cause deflection of the primary beam.

Accordingly, as a result of these advantageous features, the hot temperature specimen stage of the present invention can achieve a sample temperature of at least approximately 1500°C.

As aforementioned, the hot temperature specimen stage discussed above advantageously achieves an increased sample temperature and minimizes the temperature difference between the sample surface and the heater coil 56. However, it has been found that the foregoing hot temperature specimen stage creates an electrostatic shield around the specimen which causes inherent difficulties in extracting the electron signal through the central opening 74 of the heat shield assembly 68.

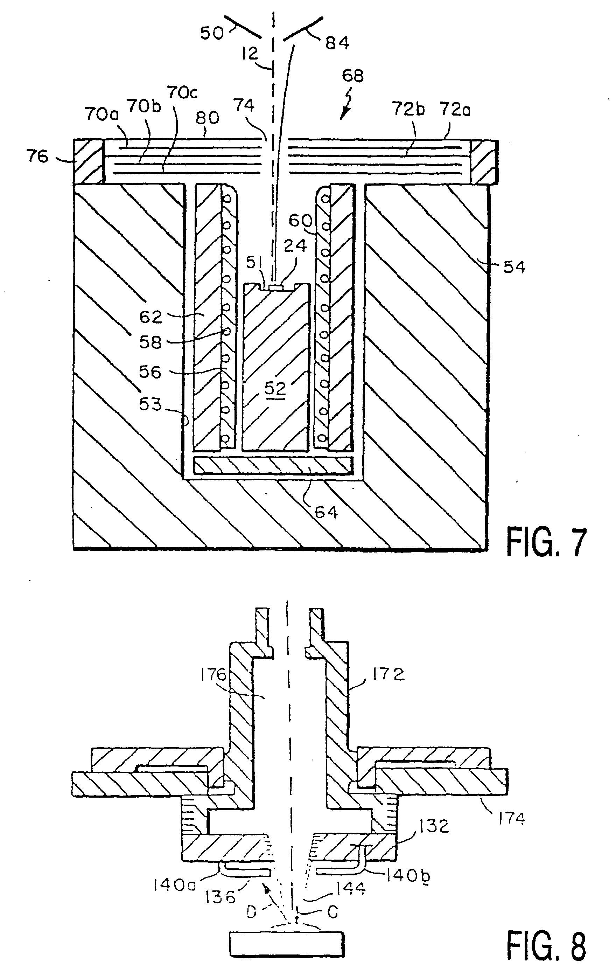

In order to alleviate this inherent problem, as is schematically shown in Fig. 7, an adjustable bias voltage 80 is applied to the heat shield assembly 68 to thereby accelerate the secondary electrons emanating from the surface of the specimen 24 to pass through the central opening 74 of the heat shield assembly and be subsequently collected by final pressure limiting aperture detector 50. Preferably, the shield bias may be positive or negative depending upon the temperature and the bias applied to the detector 50 represented by reference numeral 84 in Fig. 7. Voltages up to 500V may be required for suitable acceleration of the secondary electrons such that they are collected by the secondary electron detector 50.

Referring again to Fig. 3, a ring detector 28 was provided in the specimen chamber of the environmental scanning electron microscope of U.S. Patent Nos. 5,362,964 and 5,412,211 between the final pressure limiting aperture 14 and the specimen 24. This ring electrode detector is disclosed as being preferably formed of a thin ring, made of metal, and having a wire thickness of approximately 50 to 1000 µm. According to the '964 and '211 patents, the diameter of the ring detector 28 is slightly larger than the diameter of the final pressure limiting aperture 14 and is separated therefrom.

When the primary beam 12 strikes the specimen 24, as in Fig. 1, secondary electrons 35 and backscattered electrons, such as 37, 38 and 39, are released from the sample. For purposes of illustration in the prior ESEM of Fig. 3, the '964 and '211 patents discussed that the bias voltage was to be applied to the ring electrode 28 of approximately +500V. The bullet detector 30 which forms the final pressure limiting aperture 14 is unbiased. In this configuration, high positive voltage on the ring electrode 28 causes the secondary electrons 35 emanating from the surface of the sample to be accelerated until they strike gas molecules of the gaseous environment in the specimen chamber 22. Multiple collisions with the gaseous environment cause other electrons to be released which are, as well, accelerated towards the ring electrode 28. Some examples of signal - gas interactions which are described in U.S. Patent No. 4,992,662 to Danilatas and specifically incorporated herein are: gaseous scintillation, ionization, chemical combination, chemical disassociation, electron attachment, photo-ionization, Xray reactions, rotational and vibrational collisions, collisions characterized by a particular energy loss, etc. According to the '964 and '211 patents, there will generally be many such collisions and eventually a cloud of hundreds or thousands of electrons will reach the ring electrode 28. The main objective, however, of the ring electrode 28 is to collect the electrons triggered by secondary electrons emanating from the specimen 24.

However, as illustrated in Fig. 3, secondary electrons are also generated by gas collisions from other sources; namely:
(a) collisions between the primary beam 12 and the gaseous environment of the specimen chamber, these secondary electrons being represented by reference numeral 43 in Fig. 3;
(b) collisions between the backscattered electrons 37 that pass through the pressure limited aperture 14 and the gaseous environment of the specimen chamber 22, these secondary electrons being represented by reference numeral 45;
(c) collisions between the backscattered electrons 38 which pass through the gaseous environment between the sample 24 and the remainder of the specimen chamber, these secondary electrons being represented by reference number 47; and
(d) backscattered electrons 39 which strike the pressure limited aperture 14. and generate secondary electrons which are referred to by reference numeral 49.

All of the secondary electrons generated by these collisions are amplified by gas multiplication and the gaseous environment of the specimen chamber and add to the desired secondary electron signal. However, the secondary electrons that derive from the backscattered electrons, such as 43, 45, 47 and 49, add an undesired backscattered component to the secondary electron image being received by the ring detector 28. Furthermore, the secondary electrons 43 created by collisions between the primary beam 12 and the gaseous environment of the specimen chamber cause an undesired background noise component. Thus, in order to enhance its signal capabilities, the environmental scanning electron microscope disclosed in U.S. Patent Nos. 5,362,964 and 5,412,211 incorporated an improved secondary electron detector which reduced the backscattered electron component of the signal, such as signals 43, 45, 47 and 49 present in the Fig. 3 example, and reduced the signal noise produced by the primary beam, such as signal 43. In the embodiment of the environmental scanning electron microscope of U.S. Patent Nos. 5,362,964 and 5,412,211 shown in Fig. 4, the ring electrode 28 is biased at an electrical potential between approximately 200 and 2,000 volts, and preferably 500 volts. Additionally, a pressure limiting aperture electrode 50 is formed integrally with the bullet detector defining the final pressure limiting aperture and is biased at an electrical potential between 200 and 2,000 volts and preferably 500 volts. In the ESEM of U.S. Patent Nos. 5,362,964 and 5,412,211, the ring electrode 28 and the pressure limiting aperture electrode 50 are preferably biased at the same electrical potential.

As an example of the effect of the ESEM design of Fig. 4, if the ring electrode 28 and the final pressure limiting aperture electrode 50 are both biased at 500 volts, the desired secondary electrons 35 are accelerated and multiplied in the gaseous environment of the specimen chamber 22 to generate further secondary electrons 36 which are still collected by the ring electrode 28. However, in this configuration, most of the undesired secondary electrons are intercepted by the final pressure limiting aperture electrode 50. More specifically, the secondary electrons 45 generated by collisions with the backscattered electrons 37 are attracted to the positive surface of the pressure limiting aperture electrode 50. Further, many of the secondary electrons 47 generated by collisions between the primary beam 12 and the gaseous environment of the specimen chamber 22 are also attracted to the pressure limiting aperture electrode 50. In addition, the secondary electrons 49 generated by collisions between a backscattered electron 39 and the pressure limiting aperture 50 will no longer be accelerated away from the pressure limiting aperture and no gas amplification occurs. Accordingly, most of the undesirable signal components are not collected by the ring electrode 28, and therefore, the image signal derived from the ring electrode 28 is a more pure secondary electron image having a lower noise level.

A further object of this invention is to employ an improved gaseous electron detector in the ESEM utilizing the hot temperature specimen stage of the present invention similar to the gaseous electron detector shown in Fig. 20 of U.S. Patent 5,412,211. As is shown in Fig. 8, an environmental scanning electron microscope employing printing circuit board technology is shown. In this ESEM, a printed circuit board 132 is positioned in the specimen chamber in a generally horizontal manner. The detector body 172 is mounted to the electron optical column and provides a path of the electron beam to pass therethrough. This detector body 172 is described in U.S. Patent 5,412,211 as being similar to the aperture carrier described in U.S. Patent No. 4,823,006 assigned to the common assignee of this application except that the detector head in Fig. 8 forms the lower portion of the detector body. As is shown in Fig. 8, this detector body 172 is threaded into the electron optical column 174. In this configuration, a signal collection ring electrode 136 extends downwardly from the printed circuit board 132 by means of support legs, such as 140a and 140b, and faces the specimen 24 under examination. As a result thereof, U.S. Patent No. 5,412,211 describes that the primary beam passes through the final pressure limited aperture 144 and impinges upon the specimen 24. Secondary electrons emitted from the surface of the specimen are thus collected by the suitably biased signal ring electrode 136.

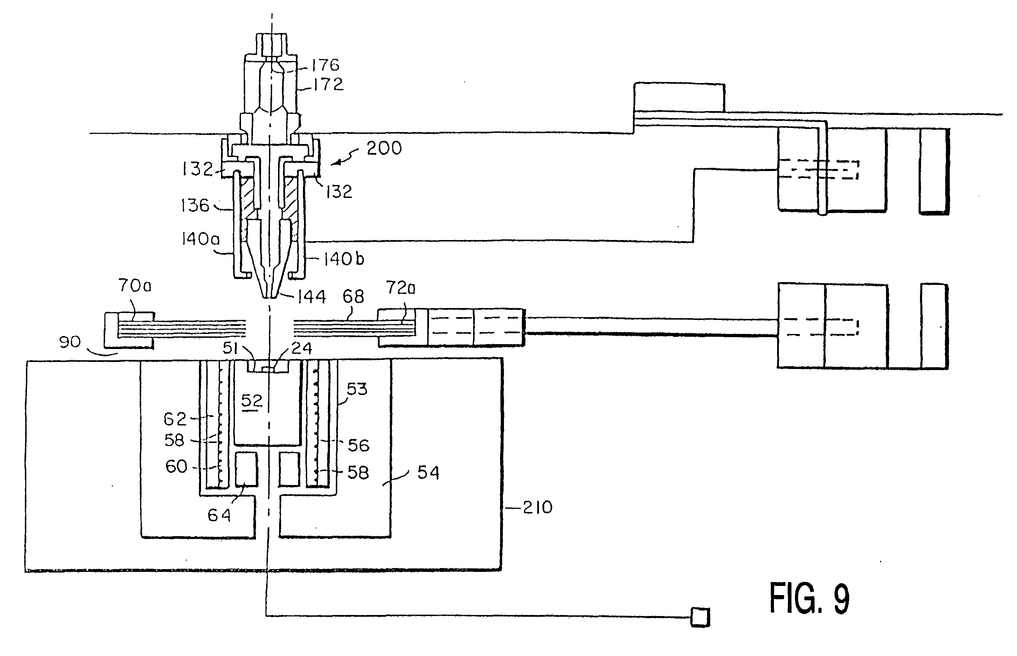

In order to minimize beam loss during the path of the electron beams through the gas between the detector and the sample, the electron beam path can be shortened by positioning the sample very close to the detector. In accordance therewith, an improved gaseous electron detector has been designed which creates a short electron beam path to the sample through the gaseous environment of the specimen chamber, but maintains a relatively long gas path to the detector. In the improved electron detector of Fig. 8, the final pressure limiting aperture 144 of the printed circuit board 132 angularly extends inwardly in an inverted conical arrangement through the collection ring electrode 136 of the printed circuit board 132. This reduces the length of the path of the electron beam through the chamber gas represented by the distance C in Fig. 8. However, the path from the sample 24 to the signal ring electrode 136 represented by the distance D is still sufficiently long enough to obtain satisfactory detection performance. The incorporation of this improved electron detector in the environmental scanning electron microscope incorporating the hot temperature specimen stage of the present invention is best illustrated in Fig. 9.

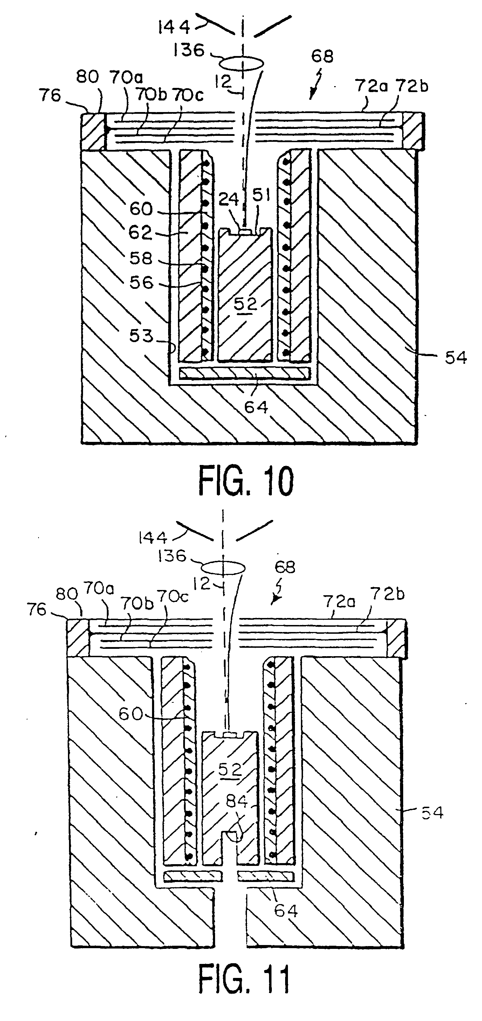

Referring now to Fig. 10, the image quality may be improved by incorporating the aforementioned features described in U.S. Patents 5,362,964 and 5,412,211, the disclosure of which is incorporated by reference. It has been found that the image quality can be further enhanced by biasing the final pressure limiting aperture 144 at a different voltage from the signal collection ring electrode 136. In practice, the final pressure limiting aperture 144 is isolated which allows the final pressure limiting aperture 144 to "float" to a stable voltage. "Floating" the bias voltage of the final pressure limiting aperture is desirable as it has been found to provide for automatic compensation. As a result thereof, superior image quality is obtained. The same performance and image quality can be achieved with a variable bias voltage, but in order to utilize a variable bias voltage, it has been found that another power supply and control of its voltage in the required way has to be provided.

A further improvement of the hot temperature specimen stage for an environmental scanning electron microscope of the present invention is schematically shown in Fig. 11 wherein the bias voltage is applied to the thermally conductive sample cup 52. More specifically, at very high temperatures (above about 800°C), the surfaces of the sample start to emit a significant amount of thermal electrons. The shield biasing scheme described above (i.e., the heat shield assembly 68) extracts these thermal electrons as well as the required secondary electrons. However, at temperatures above about 1000°C, these thermal electrons override the required secondary electrons. These thermal electrons can be suppressed by applying a bias voltage to the sample cup. This bias voltage applied to the sample cup 52 is represented by reference numeral 84 in Fig. 11. This biasing of the sample cup 52 also requires that the sample cup be electrically conductive. Bias voltages between +50 and -50V have been found to be required to suitably suppress undesired thermal electrons.

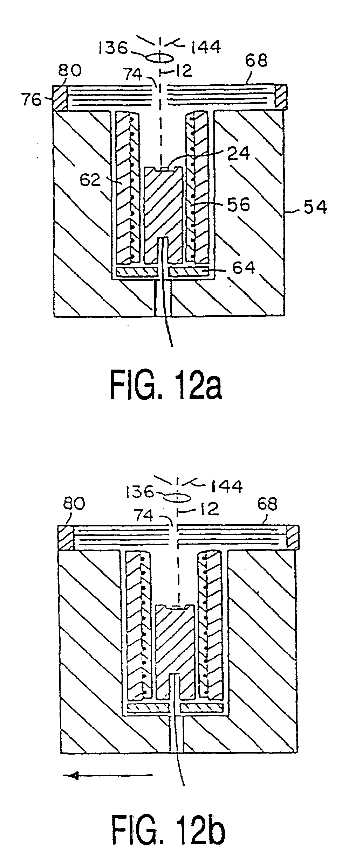

In the design of the high temperature specimen stage for an environmental scanning electron microscope of Fig. 5, the heat shield assembly 68 is formed integrally with the specimen stage. As is shown in Figs. 12a and 12b, the integrally formed stage/heat shield assembly/sample cup is moved laterally in unison in order to observe different parts of the sample. Hence, the observable area of the sample is limited by the size of the central opening 74 of the heat shield assembly 68. However, the central opening 74 of the heat shield assembly must be necessarily small (e.g., 2mm diameter) to prevent heat loss, and consequently, this relatively small opening limits the size of the sample that can be observed.

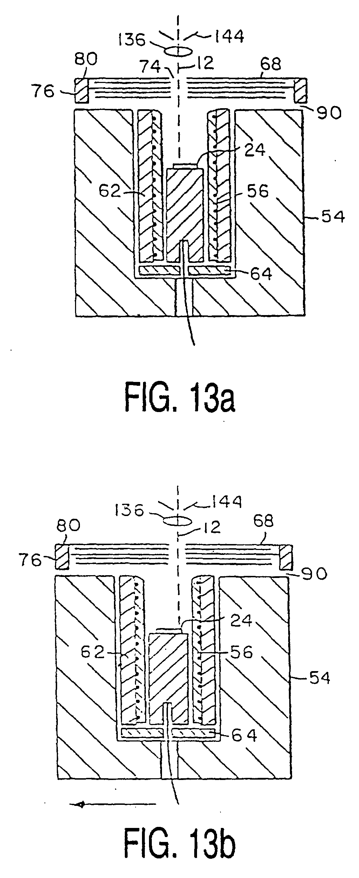

In order to overcome this problem, another preferred embodiment of the high temperature specimen stage for an environmental scanning electron microscope of the present invention is shown in Figs. 13a and 13b. As is shown in Figs. 13a and 13b, the heat shield assembly 68 is fixed in relation to the final pressure limiting aperture 144 and the signal ring electrode 136. A small gap 90 is provided between the heat shield assembly 68 and the specimen stage assembly. Thus, the specimen stage, and hence the sample 24, can be moved independently of the heat shield assembly 68. This allows a larger area of the specimen 24 to be observed, and accordingly, increases the field-of-view of the specimen. This separation of the heat shield assembly 68 from the specimen stage is further shown in Fig. 9. As is shown in Fig. 9, the specimen stage moving mechanism 210 laterally moves the specimen stage 50 independently of the heat shield assembly 68 which stays aligned with the electron detector 136 and the final pressure limiting aperture 144.

Accordingly, in accordance with the general objects of the present invention, a high temperature specimen stage for an environmental scanning electron microscope has designed which achieves sample temperatures of up to approximately 1500°C. In addition, the high temperature specimen stage for an ESEM of the present invention minimizes the temperature differential between the sample and the heater wire to maintain the top of the specimen as being at a high temperature. Moreover, the high temperature specimen stage of the present invention minimizes the magnetic field from the heating current which otherwise would cause deflection of the primary beam.

As aforementioned, in this high temperature specimen stage, the bias voltage applied to the sample cup is combined with the bias voltage applied to the heat shield assembly to suppress thermal electrons while still collecting secondary electrons. In addition, a differential voltage can be applied between the secondary electron detection ring and the pressure limiting aperture to enhance imaging quality. Further, "floating" the bias of the final pressure limiting aperture can achieve automatic compensation. Moreover, in the high temperature specimen stage of the present invention, the heat shield assembly can be mounted separately from the specimen stage so that the specimen stage can be moved independently of the heat shield assembly to enhance the field-of-view of the specimen.

Although the invention has been particularly shown and described with reference to certain preferred embodiments, it will be readily appreciated by those of ordinary skill in the art that various changes and modifications may be made therein without departing from the scope of the claims.

## Claims

1. An environmental scanning electron microscope comprising:
(a) means for generating and directing an electron beam (12) through a final pressure limiting aperture (14) toward a specimen (24) under examination, and
(b) a specimen chamber (22) which maintains the specimen enveloped in gas in registration with said final limiting aperture, said specimen chamber including a specimen stage (26) comprising sample platform means (49) for supporting the specimen under examination and specimen heating means (56) for heating said specimen,
**characterised in that**
the specimen chamber further includes a heat shield assembly (68) positioned upstream in the direction of the electron beam with respect to said heating means in said specimen chamber to avoid radiant heat loss, said heat shield assembly including a central opening (74) to permit the electron beam to pass therethrough to strike the specimen,
the environmental scanning electron microscope further comprises:
(c) means for detecting signals (28,50,84 ) emanating from the surface of the specimen, wherein an adjustable bias of up to approximately 500V is applied to said heat shield assembly to accelerate secondary electrons emanating from the specimen to pass through said central opening to be collected by said detector means and wherein a bias voltage of between approximately +50 and -50V is applied to said sample platform means to suppress thermal electrons.

2. An environmental scanning electron microscope comprising:
(a) means for generating and directing an electron beam (12) through a final pressure limiting aperture (14) toward a specimen (24) under examination;
(b) a specimen chamber (22) which maintains the specimen enveloped in gas in registration with said final pressure limiting aperture, said specimen chamber including a specimen stage (26) comprising sample platform means (49) for supporting the specimen under examination and specimen heating means (56) for heating said specimen;
**characterised in that**
the specimen chamber further includes a heat shield assembly (68) positioned upstream in the direction of the electron beam with respect to said heating means in said specimen chamber to avoid radiant heat loss, said heat shield assembly including a central opening (74) to permit the electron beam to pass therethrough to strike the specimen,
the environmental scanning electron microscope further comprises:
(c) means for detecting signals (28,50,84 ) emanating from the surface of the specimen which is formed of a thin ring electrode (28), wherein said final pressure limiting aperture is biased at a different voltage than said thin ring electrode to enhance image quality.

3. The environmental scanning electron microscope of claim 2 wherein the bias voltage applied to said final pressure limiting aperture floats to provide for automatic compensation.

4. An environmental scanning electron microscope according to claim 1 or 2 further comprising:
means (210) for laterally moving said specimen stage with respect to said heat shield assembly to enhance the field-of-view of the specimen wherein said heat shield assembly is aligned with respect to said final pressure limiting aperture and said detector means and is separated from said specimen stage so that said specimen stage moves independently of said heat shield assembly.

5. The environmental scanning electron microscope of claim 4 wherein said heat shield assembly includes a plurality of thin ceramic insulating shields (70a,70b,70c) which act as heat reflectors and a plurality of perforated metal support plates (72a,72b) integrally formed therewith to avoid warping of said heat shield assembly at high temperatures.

6. The environmental scanning electron microscope of claim 5 wherein said ceramic insulating shields are formed of alumina paper and said metal support plates are formed of perforated stainless steel.

## Patentansprüche

1. Rasterelektronenmikroskop unter kontrollierter Umgebung, das aufweist:
(a) eine Einrichtung zum Erzeugen und Leiten eines Elektronenstrahls (12) durch eine den finalen Druck begrenzende Öffnung (14) in Richtung einer Probe (24), die untersucht wird, und
(b) eine Probenkammer (22), die die Probe entsprechend der den finalen Druck begrenzenden Öffnung in Gas eingehüllt hält, wobei die Probenkammer einen Probentisch (26) umfaßt, der eine Probenplattformeinrichtung (49) zum Halten der Probe, die untersucht wird, und eine Probenheizungseinrichtung (56) zum Heizen der Probe aufweist,
**dadurch gekennzeichnet, daß**
die Probenkammer ferner eine Wärmeabschirmungsanordnung (68) umfaßt, die bezüglich der Heizungseinrichtung in Aufwärtsrichtung des Elektronenstrahls in der Probenkammer positioniert ist, um Strahlungswärmeverluste zu vermeiden, wobei die Wärmeabschirmungsanordnung eine Mittelöffnung (74) aufweist, um es dem Elektronenstrahl zu ermöglichen, hindurch zu laufen und auf die Probe zu treffen,
wobei das Rasterelektronenmikroskop unter kontrollierter Umgebung ferner aufweist:
(c) eine Einrichtung zum Detektieren von Signalen (28, 50, 84), die aus der Oberfläche der Probe austreten, wobei eine einstellbare Vorspannung von bis zu 500 V an die Wärmeabschirmungsanordnung angelegt wird, um von der Probe austretende Sekundärelektronen zu beschleunigen, so daß sie durch die Mittelöffnung laufen, um von der Detektoreinrichtung erfaßt zu werden, und wobei eine Vorspannung zwischen etwa +50 und -50 V an die Probenplattformeinrichtung angelegt wird, um thermische Elektronen zu unterdrücken.

2. Rasterelektronenmikroskop unter kontrollierter Umgebung, das aufweist:
(a) eine Einrichtung zum Erzeugen und Leiten eines Elektronenstrahls (12) durch eine den Druck begrenzende Öffnung (14) in Richtung einer Probe (24), die untersucht wird, und
(b) eine Probenkammer (22), die die Probe entsprechend der Kammer in Gas eingehüllt hält, wobei die Probenkammer einen Probentisch (26) umfaßt, der eine Probenplattformeinrichtung (49) zum Halten der Probe, die untersucht wird, und eine Probenheizungseinrichtung (56) zum Heizen der Probe aufweist,
**dadurch gekennzeichnet, daß**
die Probenkammer ferner eine Wärmeabschirmungsanordnung (68) umfaßt, die bezüglich der Heizungseinrichtung in Aufwärtsrichtung des Elektronenstrahls in der Probenkammer positioniert ist, um Strahlungswärmeverluste zu vermeiden, wobei die Wärmeabschirmungsanordnung eine Mittelöffnung (74) aufweist, um es dem Elektronenstrahl zu ermöglichen, hindurch zu laufen und auf die Probe zu treffen,
wobei das Rasterelektronenmikroskop unter kontrollierter Umgebung ferner aufweist:
(c) eine Einrichtung zum Detektieren von Signalen (28, 50, 84), die aus der Oberfläche der Probe austreten, welche aus einer dünnen Ringelektrode (28) gebildet ist, wobei die den Druck begrenzende Öffnung eine andere Vorspannung als die dünne Ringelektrode hat, um die Bildqualität zu verbessern.

3. Rasterelektronenmikroskop unter kontrollierter Umgebung nach Anspruch 2, wobei die an die den finalen Druck begrenzende Öffnung angelegte Vorspannung sich selbst einstellt, um für einen automatischen Ausgleich zu sorgen.

4. Rasterelektronenmikroskop unter kontrollierter Umgebung nach Anspruch 1 oder 2, die ferner aufweist:
eine Einrichtung (210) zum seitlichen Bewegen des Probentisches relativ zu der Wärmeabschirmungsanordnung, um das Sichtfeld der Probe zu verbessern, wobei die Wärmeabschirmungsanordnung relativ zu der den finalen Druck begrenzende Öffnung und der Detektoreinrichtung ausgerichtet ist und von dem Probentisch getrennt ist, so daß der Probentisch sich unabhängig von der Wärmeabschirmungsanordnung bewegt.

5. Rasterelektronenmikroskop unter kontrollierter Umgebung nach Anspruch 4, wobei die Wärmeabschirmungsanordnung mehrere dünne keramische Isolierschirme (70a, 70b, 70c), die als Wärmereflektoren wirken, und mehrere integral damit ausgebildete perforierte Metallträgerplatten (72a, 72b) umfaßt, um das Verbiegen der Wärmeabschirmungsanordnung bei hohen Temperaturen zu vermeiden.

6. Rasterelektronenmikroskop unter kontrollierter Umgebung nach Anspruch 5, wobei die keramischen Isolierschirme aus Aluminiumoxidpapier geformt sind und die Metallträgerplatten aus perforiertem nichtrostendem Stahl gefertigt sind.

## Revendications

1. Microscope électronique à balayage dans l'atmosphère, comprenant :
a) des moyens pour générer et diriger un faisceau électronique (12) à travers une ouverture de limitation de pression finale (14) vers un objet (24) en cours d'examen, et
b) un sas (22) qui maintient l'objet enveloppé dans un gaz en alignement avec ladite ouverture de limitation finale, ledit sas comprenant une platine porte-objet (26) comprenant une des moyens de plate-forme porte-échantillon (49) pour supporter l'objet en cours d'examen et des moyens de chauffage d'objet (56) pour chauffer ledit objet,
**caractérisé en ce que**
le sas comprend en outre un ensemble de protection thermique (68) positionné en amont dans la direction du faisceau électronique par rapport auxdits moyens de chauffage dans ledit sas pour éviter toute perte de chaleur rayonnante, ledit ensemble de protection thermique comprenant une ouverture centrale (74) pour laisser passer le faisceau électronique à travers celle-ci pour frapper l'objet,
le microscope électronique à balayage dans l'atmosphère comprenant en outre :
c) des moyens pour détecter des signaux (28, 50, 84) émanant de la surface de l'objet, dans lesquels une polarisation réglable allant jusqu'à environ 500 V est appliquée audit ensemble de protection thermique pour accélérer les électrons secondaires émanant de l'objet pour qu'ils passent à travers ladite ouverture centrale afin d'être captés par lesdits moyens de détection, et dans lesquels une tension de polarisation entre environ +50 et -50 V est appliquée auxdits moyens de plate-forme porte-échantillon pour supprimer les électrons thermiques.

2. Microscope électronique à balayage dans l'atmosphère, comprenant :
a) des moyens pour générer et diriger un faisceau électronique (12) à travers une ouverture de limitation de pression finale (14) vers un objet (24) en cours d'examen,
b) un sas (22) qui maintient l'objet enveloppé dans un gaz en alignement avec ladite ouverture de limitation de pression finale, ledit sas comprenant une platine porte-objet (26) comprenant une des moyens de plate-forme porte-échantillon (49) pour supporter l'objet en cours d'examen et des moyens de chauffage d'objet (56) pour chauffer ledit objet,
**caractérisé en ce que**
le sas comprend en outre un ensemble de protection thermique (68) positionné en amont dans la direction du faisceau électronique par rapport auxdits moyens de chauffage dans ledit sas pour éviter toute perte de chaleur rayonnante, ledit ensemble de protection thermique comprenant une ouverture centrale (74) pour laisser passer le faisceau électronique à travers celle-ci pour frapper l'objet,
le microscope électronique à balayage dans l'atmosphère comprenant en outre :
c) des moyens pour détecter des signaux (28, 50, 84) émanant de la surface de l'objet qui se compose d'une électrode annulaire mince (28), dans lesquels ladite ouverture de limitation de pression finale est polarisée à une tension différente de celle de ladite électrode annulaire mince pour améliorer la qualité d'image.

3. Microscope électronique à balayage dans l'atmosphère selon la revendication 2, dans lequel la tension de polarisation appliquée à ladite ouverture de limitation de pression finale est flottante pour assurer une compensation automatique.

4. Microscope électronique à balayage dans l'atmosphère selon la revendication 1 ou 2, comprenant en outre :
des moyens (210) pour déplacer latéralement ladite platine porte-objet par rapport audit ensemble de protection thermique pour améliorer le champ optique de l'objet, dans lesquels ledit ensemble de protection thermique est aligné par rapport à ladite ouverture de limitation de pression finale et auxdits moyens de détection et est séparé de ladite platine porte-objet de sorte que ladite platine porte-objet se déplace indépendamment dudit ensemble de protection thermique.

5. Microscope électronique à balayage dans l'atmosphère selon la revendication 4, dans lequel ledit ensemble de protection thermique comprend une pluralité d'écrans isolants céramiques (70a, 70b, 70c), qui agissent comme des réflecteurs thermiques, et une pluralité de plateaux de support métalliques perforés (72a, 72b) intégrés à ceux-ci pour éviter la déformation dudit ensemble de protection thermique à des températures élevées.

6. Microscope électronique à balayage dans l'atmosphère selon la revendication 5, dans lequel lesdits écrans isolants céramiques sont formés en papier d'alumine et lesdits plateaux de support métalliques sont formés en acier inoxydable perforé.
